# EUROPÄISCHE PATENTANMELDUNG

(11) **EP 1 387 398 A2**
(43) Veröffentlichungstag der Anmeldung: **04.02.2004**
(21) Anmeldenummer: 03015790.3
(22) Anmeldetag: 10.07.2003
(51) Int. Cl.: H01L 21/60

(54) **Verfahren und Klebstoff zur Flip-Chip-Kontaktierung**

(30) Priorität: 18.07.2002 DE 10232636
(71) Anmelder: DELO Industrieklebstoffe GmbH & Co. KG, 86899 Landsberg (DE)
(72) Erfinder: Dengler, Dietmar, Dr., 86899 Landsberg (DE); Herold, Wolf-Dietrich, Dr., 86911 Diessen (DE); Möst, Rainer, 82110 Germering (DE)
(74) Vertreter: Strehl Schübel-Hopf & Partner

(57) **Zusammenfassung**

Zur Flip-Chip-Kontaktierung wird ein elektrisch leitende, verformbare Partikel **10** enthaltender Klebstoff **11** auf ein mit Kontaktflächen **12** versehenes Substrat **13** aufgetragen, ein mit Kontaktflächen **14** versehener Chip **15** in der richtigen Position zum Substrat **13** plaziert, der Klebstoff **11** im Umfangsbereich **16** zwischen Chip **15** und Substrat **13** versiegelt und danach der unter dem Chip **15** befindliche Klebstoff **11** ausgehärtet. Der beim Aushärten auftretende Schrumpf bewirkt, das Chip **15** und Substrat **13** gegeneinander gezogen werden, so daß auf äußere Druckanwendung während der Aushärtung des Klebstoffs **11** verzichtet werden kann. Durch kurzzeitige Druckanwendung läßt sich der gesamte Aushärtvorgang beschleunigen.

## Beschreibung

Bei der sogenannten Flip-Chip-Kontaktierung wird ein mit Kontaktflächen versehener Chip, der beispielsweise eine integrierte Schaltung enthält, auf ein mit Kontaktflächen versehenes Substrat geklappt und durch Klebstoff mit diesem verbunden, wobei gegenüberliegende Kontaktflächen über elektrisch leitende Teile miteinander kontaktiert werden. Im Vergleich zur herkömmlichen Drahtkontaktierung ermöglicht dieses Verfahren eine erhebliche Steigerung der Packungs- und Anschlußdichten.

Bei einem aus EP 1 205 970 A2 bekannten Verfahren werden als leitende Teile Edelmetallhöcker auf die Kontaktflächen des Chips aufgetragen, die eine zwischen Chip und Substrat eingebrachte, zunächst flüssige Klebstoffschicht durchdringen. Während der Aushärtung des Klebstoffs werden Chip und Substrat gegeneinander gepreßt, um sicheren elektrischen Kontakt zwischen den Höckern und den Kontaktflächen des Substrats zu gewährleisten.

Der Anpreßdruck muß während relativ langer Zeit aufrecht erhalten bleiben. Auch wenn sich die Aushärtung durch starke Temperaturerhöhung beschleunigen läßt, muß der Anpreßdruck mindestens für mehrere Sekunden aufrecht erhalten werden. Für die Herstellung von elektronischen Bauteilen in hohen Stückzahlen ist dieser Zeitaufwand nachteilig. Auch die Herstellung der Höcker ist teuer und zeitaufwendig; vergleiche DE 44 42 960 C1 und DE 195 24 739 A1.

Ferner geht der Trend in der Entwicklung von Chips zu immer geringeren Schichtdicken, bei denen die Gefahr besteht, das sie durch den Anpreßdruck deformiert und in ihrer Funktion beeinträchtigt werden.

Aus US 2002/0014688 A1 ist ein Verfahren bekannt, bei dem zur Kontaktierung von Chips und Substrat metallisches Lot verwendet wird, das auf die Anschlußflächen des Substrats oder des Chips gezielt aufgebracht wird. Durch Aufschmelzen des Lots nach der Kontaktierung wird die elektrisch leitende Verbindung hergestellt. Anschließend wird der Verbund durch einen Klebstoff (Underfüler) stabilisiert.

Der flüssige Klebstoff muß den Chip vollständig unterfließen und ausgehärtet werden. Anschließend wird er gegen das Eindringen von Feuchtigkeit in seinem Randbereich versiegelt. Nachteilig ist wiederum, das der Zeitbedarf für das Einbringen und Aushärten des Klebstoffs einer rationellen Fertigung großer Stückzahlen entgegensteht.

JP 0425343 A beschreibt ein Verfahren, bei dem ein LSI-Chip mit einer Leiterplatte durch Schrumpfung einer dazwischen angeordneten Schrumpffolie und eines im Randbereich vorhandenen Kunststoffs in engen Kontakt gebracht wird. Die Schrumpffolie verhindert die Ausnutzung der einander gegenüberstehenden Flächen von Chip und Leiterplatte für Kontaktzwecke.

Aus JP 10074799 A ist ein Flip-Chip-Kontaktierverfahren bekannt, bei dem zwischen Chip und Leiterplatte sowohl im inneren als auch im Randbereich vorhandene Klebstoffe gleichzeitig und unter äußerer Druckanwendung ausgehärtet werden, wobei die in dem Rand-Klebstoff auftretende Schrumpfung dazu dienen soll, die beiden Bauteile mit hoher Festigkeit miteinander zu verbinden. Die Aushärtung erfolgt dabei durch UV-Strahlung und Wärme.

Ein in DE 199 05 897 A1 beschriebenes weiteres Verfahren arbeitet mit einem Klebstoff, der leitende Partikel in Form von mit Gold und Nickel beschichteten, elastischen Kunststoffkügelchen enthält.

Bei einem weiteren, aus DE 196 40 192 A1 bekannten Flip-Chip-Kontaktierverfahren wird der gesamt Zwischenraum zwischen Chip und Substrat mit einem Lotpartikel enthaltenden Epoxidharz ausgefüllt, der unter einem äußeren Druck von 10 kg/cm² und einer Temperatur von 150-180 °C 60 bis 90 s lang ausgehärtet wird.

Gemäß JP 20000236002 A ist der Chip mit Au-Kontaktbumps versehen, die mit einer Ag-Paste überzogen sind. Die Ag-Paste und ein zwischen Chip und Substrat eingebrachtes Kunstharz werden in einem Erwärmungsvorgang gleichzeitig gehärtet.

JP 2002057191 A, JP 06034992 A und WO 00/74023 offenbaren einen Klebstoff für Flip-Chip-Kontaktierungen, der sowohl leitende als auch nicht-leitende Partikel enthält.

Der vorliegenden Erfindung liegt die generelle Aufgabe zugrunde, Nachteile, wie sie bei vergleichbaren Kontaktierverfahren nach dem Stand der Technik auftreten, mindestens teilweise zu beseitigen. Eine speziellere Aufgabe der Erfindung besteht darin, eine Flip-Chip-Kontaktierung in einem sehr schnellen Prozeß zu ermöglichen, ohne die Chipmetallisierung anzugreifen oder zu zerstören.

Diese Aufgabe wird durch die in den Ansprüchen 1 und 10 angegebenen Verfahren gelöst. Ein dabei verwendbarer Klebstoff ist in Anspruch 13 gekennzeichnet.

In beiden Fällen kann die Aushärtung des Klebstoffs ohne ganz äußere Druckanwendung oder mit nur sehr kurzer äußerer Druckanwendung erfolgen, so daß der beim Stand der Technik dafür erforderliche Zeitbedarf entfällt oder abgekürzt wird.

Gemäß Anspruch 1 wird eine zuverlässige Kontaktierung zwischen Chip und Substrat dadurch erreicht, daß der Schrumpf des Klebstoffs ein Zusammenpressen von Substrat und Chip erzwingt. Dazu wird der während der Polymerisation des Klebstoffs stattfindende Schrumpf nur in der Verbindungsrichtung Chip/Substrat manifestiert. Da ein Großteil des bei der Polymerisation eines Klebstoffs stattfindenden Schrumpfes zu Beginn der Aushärtung erfolgt, würde ohne die erfindungsgemäße Versiegelung des Umfangsbereichs der Volumenschwund durch Nachziehen von noch flüssigem Klebstoff aus dem Umfangsbereich ausgeglichen.

Eine besonders einfache Versiegelung besteht gemäß Anspruch 2 darin, wenn der Klebstoff selbst in seinem Umfangsbereich selektiv ausgehärtet wird, bevor die Polymerisation in seinem Hauptvolumen einsetzt. Die Ansprüche 3 bis 6 und 8 geben verschiedene geeignete Wege für eine solche selektive Aushärtung an.

Ein besonders einfach durchzuführendes Verfahren ergibt sich bei Anwendung der in Anspruch 7 angegebenen Maßnahme.

Die Ausgestaltung der Erfindung nach Anspruch 9 ist insofern von Vorteil, als Partikel, die durch den Schrumpf bei der Aushärtung verformt werden, eine sichere elektrische Verbindung von Chip und Substrat gewährleisten.

Bei dem Verfahren nach Anspruch 10 wird die Tatsache ausgenutzt, daß durch das Anfließen der in diesem Fall verflüssigbaren leitenden Partikel an Chip und Substrat Haftungskräfte aufgebaut werden. Die Partikel erhalten dabei eine von der Kugelform abweichende Geometrie, die eine sichere Kontaktierung gewährleistet. Daher kann auch hier entweder auf äußere Druckanwendung verzichtet oder mit Druckanwendung über eine Zeitspanne von nur wenigen Sekunden gearbeitet werden.

Da ferner beim Anschmelzen der elektrisch leitenden Partikel eine Selbstausrichtung von Chip und Substrat stattfindet, braucht die Positioniergenauigkeit bei der gegenseitigen Ausrichtung der Kontaktflächen von Chip und Substrat nicht besonders hoch zu sein.

Durch die Maßnahme des Anspruchs 11 bzw. den in Anspruch 13 angegebenen Klebstoff wird verhindert, daß die verflüssigten leitenden Partikel zusammenfließen und damit einen Kurzschluß bewirken.

Die Anwendung der in Anspruch 12 angegebenen Maßnahme führt zu einem besonders einfach durchzuführenden Verfahren.

Die Weiterbildung der Erfindung nach den Ansprüchen 14 und 15 ist insofern günstig, als beim Plazieren des Chips auf das Substrat ein Kontakt der elektrisch leitfähigen Partikel zu den beiden Fügepartnern gewährleistet wird.

Gemäß Anspruch 16 ist für die verflüssigbaren leitenden Partikel partikelförmiges Lot gut geeignet, wobei besonders gute Leitfähigkeit des Verbundes erreicht wird, wenn der Klebstoff gemäß Anspruch 17 Fluxmitteleigenschaften aufweist, um oxidische Oberflächen auf den Lotpartikeln zu beseitigen.

Ausführungsbeispiele der erfindungsgemäßen Verfahren werden nachstehend anhand der Zeichnungen näher erläutert. Darin zeigen
- Fig. 1 bis 4: einen schematischen Schnitt durch eine Anordnung aus einem Halbleiterchip, einem Substrat und einer dazwischen befindlichen Klebstoffschicht in aufeinander folgenden Stadien eines ersten Flip-Chip-Kontaktierverfahrens, und
- Fig. 5 bis 7: einen schematischen (in Fig. 6 und 7 vergrößerten) Schnitt durch eine ähnliche Anordnung in aufeinander folgenden Stadien eines zweiten Flip-Chip-Kontaktierverfahrens.

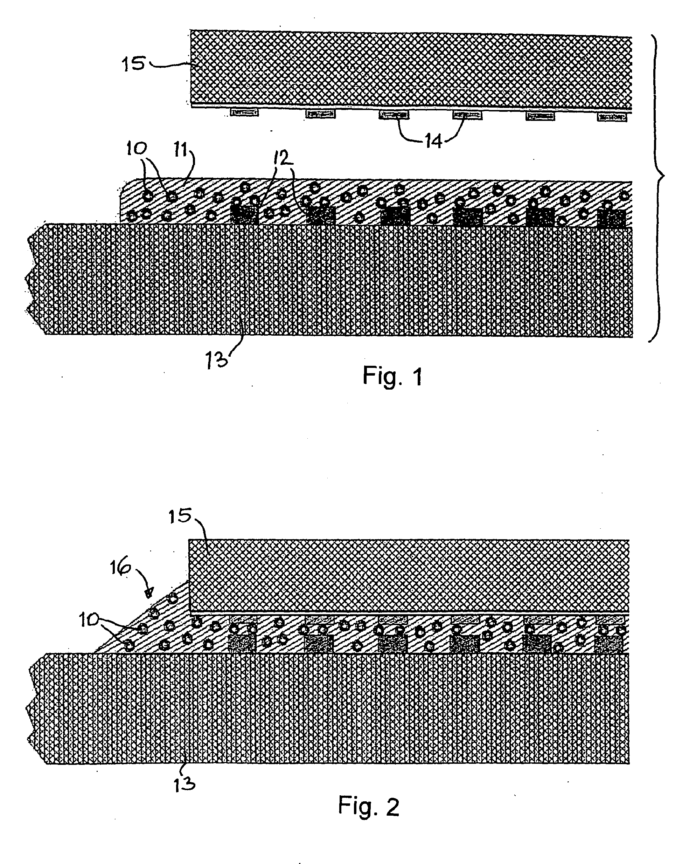

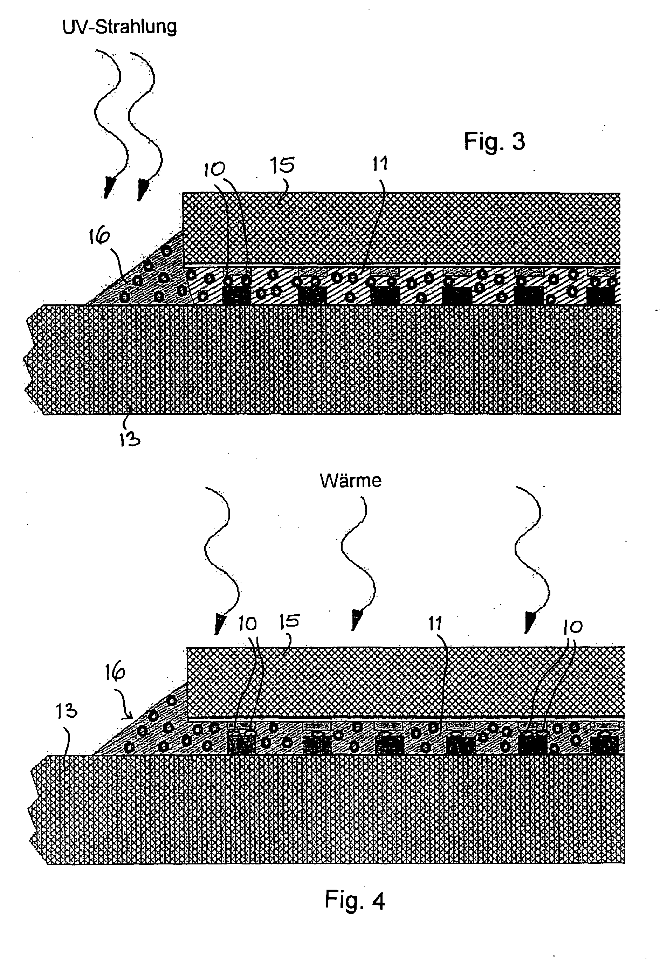

Das in Fig. 1 bis 4 schematisch dargestellte Verfahren besteht aus folgenden aufeinander folgenden Schritten:
(1) Auftragen eines elektrisch leitenden, verformbare Partikel **10** enthaltenden Klebstoffs **11** als auf ein mit Kontaktflächen **12** versehenes Substrat **13** (Fig. 1),
(2) Plazieren eines mit Kontaktflächen **14** versehenen Chips **15** in der richtigen Position zum Substrat **13** (Fig. 2),
(3) Versiegeln des Klebstoffs **11** durch ein im Umfangsbereich **16** zwischen Chip **15** und Substrat **13** befindliches, nicht fließfähiges Material (Fig. 3), und
(4) Aushärten des unter dem Chip **15** befindlichen Klebstoffs **11** (Fig. 4).

Das Verfahren wird entweder ohne oder nur sehr kurzzeitige Anwendung von externem Anpreßdruck während der Aushärtung des Klebstoffs **11** durchgeführt. Vielmehr erzwingt der Schrumpf des Klebstoffs **11** ein Zusammenpressen von Substrat **13** und Chip **15**. Da ein Großteil des bei der Polymerisation des Klebstoffs **11** stattfindenden Schrumpfes zu Beginn der Aushärtung erfolgt, würde der Volumenschwund im noch flüssigen Klebstoff **11** durch Nachziehen aus dem Umfangsbereich **16** ausgeglichen. Um diesen Ausgleich zu verhindern, wird das Material im Umfangsbereich **16** im Schritt (3) versiegelt, bevor im Schritt (4) die Hauptmasse des Klebstoffs **11** unter dem Chip **15** polymerisiert wird.

Der für das Aneinanderpressen von Chip **15** und Substrat **13** nutzbare Schrumpf erfolgt erst nach Aufbau einer Adhäsion des Klebstoffs **11** sowohl zu Substrat **13** als auch Chip **15** sowie nach einer ausreichenden Verfestigung des Materials im Umfangsbereich **16**, was ein Nachfließen von flüssigem Material oder Luft verhindert. Ohne den Schritt (3) würde ein Großteil des Volumenschrumpfes für die Verpressung von Chip **15** und Substrat **13** verloren gehen. Dieser Verlust wird dadurch vermieden, daß der flüssige Klebstoff **11** unter dem Chip **15** vor seiner Aushärtung versiegelt wird.

Die Versiegelung des Umfangsbereichs **16** kann durch beliebige nicht fließfähige Materialien wie z.B. Wachse, Kunststoffe, Metalle geschehen. In dem gezeigten Ausführungsbeispiel ist das Material mit dem Klebstoff **11** identisch, der selektiv in dem Umfangsbereich **16** vor der Aushärtung im Hauptbereich polymerisiert wird. Die getrennte Polymerisation geschieht dadurch, daß zunächst der Umfangsbereich **16** durch UV-Strahlung und anschließend die Hauptmasse durch Wärme ausgehärtet wird.

Der elektrische Kontakt zwischen den Kontaktflächen **12** des Substrats **13** und den Kontaktflächen **14** des Chips **15** kommt über die in dem Klebstoff **11** enthaltenen elektrisch leitenden Partikel **10** zustande. Die Partikel **10** werden durch die Schrumpfkraft bei der Aushärtung verformt, so daß sie eine sichere elektrische Verbindung zwischen den Kontaktflächen **12**, **14** gewährleisten.

Eine weitere Möglichkeit der selektiven Versiegelung des Randbereichs besteht darin, daß ein kationisch voraktivierbarer Klebstoff verwendet wird, der nach seinem Auftrag mit Licht aktiviert wird und nach einer längeren Zeit in Dunklen sicher und vollständig aushärtet. Dabei wird der Chip in dem voraktivierten Klebstoff plaziert und in dem nach außen freiliegenden Randbereich durch nochmalige Bestrahlung sehr schnell ausgehärtet. Die unter dem Chip befindliche Klebstoffmenge ist gegen die zweite Bestrahlung geschützt und härtet viel langsamer aus. Der dabei auftretende Schrumpf führt, wie oben beschrieben, zu der Verpressung von Chip und Substrat.

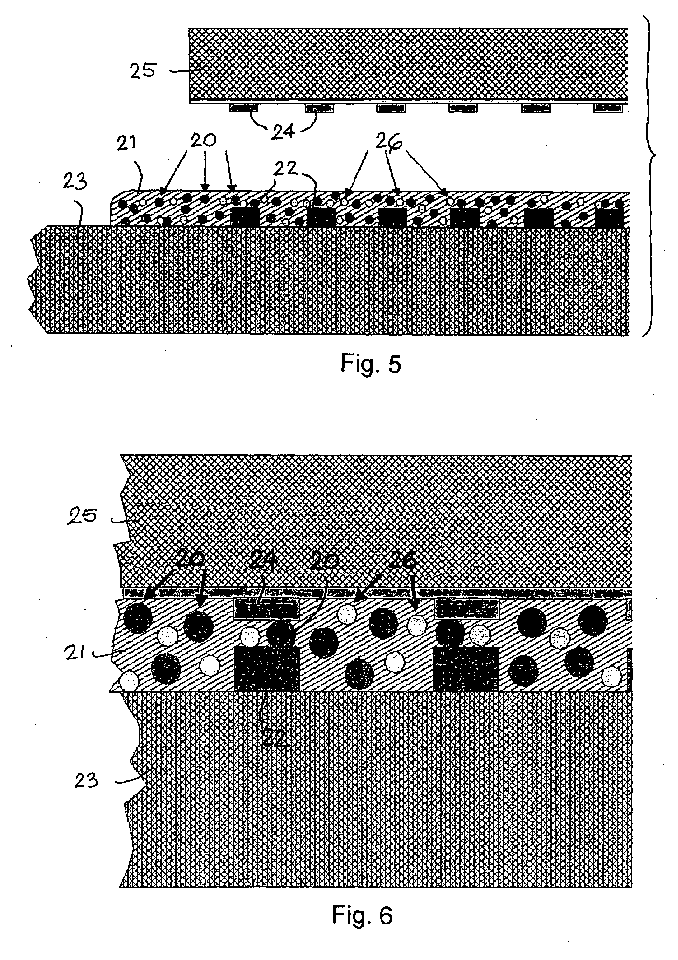

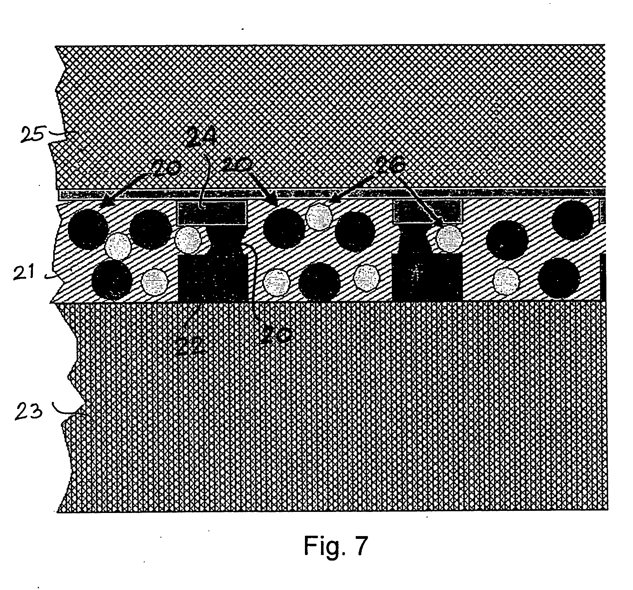

Das in Fig. 5 bis 7 schematisch dargestellte Flip-Chip-Kontaktierverfahren besteht aus folgenden aufeinander folgenden Schritten:
(1) Applizieren eines Lotpartikel **20** und nicht-leitfähige kugelförmige Abstandhalterteilchen **26** enthaltenden, Fluxmitteleigenschaften aufweisenden Klebstoffs **21** auf ein mit Kontaktflächen **22** versehenes Substrat **23** (Fig. 5),
(2) Positionieren eines mit Kontaktflächen **24** versehenen Chips **25** auf dem Substrat **23** (Fig. 6),
(3) Erwärmen der Anordnung bis zum Aufschmelzen der Lotpartikel **20** und Anfließen an die Kontaktflächen **22**, **24** von Substrat **23** und Chip **25** (Fig. 7), und
(4) Aushärten des Klebstoffs **21**.

Beim Aufschmelzen der Lotpartikel **20** findet eine Selbstausrichtung von Chip **25** und Substrat **23** statt, so daß im Schritt (2) keine besonders genaue Positionierung erforderlich ist. Durch die Fluxmitteleigenschaften des Klebstoffs **21** werden oxidische Oberflächen auf den Lotpartikeln **20** beseitigt, so daß diese gut an die Kontaktflächen **22**, **24** anfließen.

Die in dem Klebstoff **21** enthaltenen Abstandhalterteilchen **26** verhindern, daß beim Aufschmelzen der Lotpartikel **20** der Chip **25** so weit zum Substrat **23** gezogen wird, daß eine flache durchgängige Lotschicht entsteht, die zu Kurzschluß zwischen nicht miteinander zu verbindenden Kontaktflächen **22**, **24** führen würde.

Ein Anpressen des Chips **25** gegen das Substrat **23** kann bei der Verwendung der Lotpartikel **20** entfallen, da diese durch das Anfließen an Chip **25** und Substrat **23** Haftungskräfte aufbauen, die sich in der Verformung der Lotpartikel (Fig. 7) zeigen und eine sichere Kontaktierung gewährleisten.

Aushärtezeit und -temperatur des Klebstoffs **21** werden so gewählt, daß zuerst die Lotpartikel **20** schmelzen und danach eine schnelle Aushärtung des Klebstoffs **21** erfolgt. Dies ist durch den aufeinander abgestimmten Einsatz von Lot und Härter in dem Klebstoff **21** möglich.

Bevorzugt werden niedrigschmelzende Weichlote eingesetzt. Als Beispiele seien Bismut:Zinn 58:42 (eutektisch), Schmelzpunkt 138°C, Bismut: Blei 55,5:44,5 (eutektisch), Schmelzpunkt 124 °C und Indium:Blei:Silber 80:12:5, Schmelzpunkt 149 °C genannt. Aber auch höherschmelzende Lote können eingesetzt werden, solange sie aufschmelzen, bevor der Klebstoff **21** ausgehärtet ist.

Statt der Lotpartikel **20** sind auch elektrisch leitfähige Materialien einsetzbar, die als Flüssigkeiten oder in einen fließfähigen Zustand überführbare Feststoffe vorliegen und in einer definierten Tropfengröße bzw. Partikelgröße in dem Klebstoff **21** emulgiert oder dispergiert werden können. Als Beispiele seien elektrisch leitfähige Polymere wie Polyanilin, Polypyrrole, Polypharaphenylen, Polythiophen, trans-Polyacetylen genannt.

Die Abstandhalterteilchen **26** sind etwas kleiner als die Lotpartikel **20**. Sie können auch kompressibel sein. Bei der Plazierung des Chips **25** auf das Substrat **23** entsteht somit ein Kontakt der Lotpartikel **20** zu den beiden Fügepartnern **23**, **25**.

Die Lotpartikel **20** (bzw. die emulgierten, elektrisch leitfähigen Flüssigkeiten oder anderen in einen fließfähigen Zustand überführbaren, elektrisch leitfähigen Feststoffe) sind in einer Menge von 0,1 bis 80 % bezogen auf das Gesamtgewicht enthalten. Bevorzugt enthalten sind 0,5 bis 30 % Lotpartikel **20**, besonders bevorzugt 3 bis 20 % bzw. 1 bis 50 %. Die Abstandhalterteilchen **26** sind zu 0,001 bis 40 % enthalten, bevorzugt 0,005 bis 20 %. Der Beginn der Aushärtereaktion des Klebstoffs **21** liegt in einem Bereich von max. 10 °C unter und 50 °C über der Schmelztemperatur der Lotpartikel **20** (bzw. der Anfließtemperatur der elektrisch leitfähigen Flüssigkeit an die Kontaktflächen **22**, **24**).

## Patentansprüche

1. Flip-Chip-Kontaktierverfahren, bei dem Kontaktflächen (**12**) an einem Substrat (**13**) mit gegenüberliegenden Kontaktflächen (**14**) an einem Chip (**15**) kontaktiert und der Chip (**15**) mit dem Substrat (**13**) mittels eines Klebstoffs (**11**) verbunden wird,
**dadurch gekennzeichnet, daß** der unter Schrumpfung aushärtende Klebstoff (**11**) vor seiner Aushärtung im Umfangsbereich (**16**) der Anordnung nach außen versiegelt wird.

2. Verfahren nach Anspruch 1, **dadurch gekennzeichnet, daß** die Versiegelung durch selektive Aushärtung des Klebstoffs (**11**) nur im Umfangsbereich (**16**) erfolgt.

3. Verfahren nach Anspruch 1, **dadurch gekennzeichnet, daß** die Versiegelung mittels eines von dem Klebstoff (**11**) verschiedenen Materials erfolgt.

4. Verfahren nach Anspruch 2, **dadurch gekennzeichnet, daß** der Klebstoff (**11**) im Umfangsbereich (**16**) nach einem anders induzierten Mechanismus ausgehärtet wird als im übrigen Bereich.

5. Verfahren nach Anspruch 4, **dadurch gekennzeichnet, daß** das Versiegelungsmaterial (**11**) durch UV-Strahlung und der Klebstoff (**11**) durch Wärme ausgehärtet werden.

6. Verfahren nach Anspruch 2, **dadurch gekennzeichnet, daß** der Klebstoff (**11**) kationisch voraktiviert und im Umfangsbereich (**16**) durch eine zweite Bestrahlung rasch ausgehärtet wird, während die übrige Klebstoffmenge durch den Chip gegen die zweite Bestrahlung geschützt ist.

7. Verfahren nach einem der vorhergehenden Ansprüche, **dadurch gekennzeichnet, daß** in dem aufzutragenden Klebstoff (**11**) elektrisch leitende Partikel (**10**) enthalten sind.

8. Verfahren nach einem der Ansprüche 4 bis 7, **dadurch gekennzeichnet, daß** der Klebstoff sowohl durch UV-Strahlung als auch durch Wärme aushärtbar ist.

9. Verfahren nach einem der vorhergehenden Ansprüche, **dadurch gekennzeichnet, daß** die Partikel (**10**) durch Druck verformbar sind.

10. Flip-Chip-Kontaktierverfahren, bei dem Kontaktflächen (**22**) an einem Substrat (**23**) mit gegenüberliegenden Kontaktflächen (**24**) an einem Chip (**25**) über elektrisch leitende Partikel (**20**) kontaktiert und der Chip (**25**) mit dem Substrat (**23**) mittels eines die Partikel (**20**) umgebenden Klebstoffs (**21**) verbunden wird,
**dadurch gekennzeichnet, daß** die Anordnung bis zum Anfließen der verflüssigbaren Partikel (**20**) an die Kontaktflächen (**22**, **24**) erwärmt und anschließend der Klebstoff (**21**) ausgehärtet wird.

11. Verfahren nach Anspruch 10, **dadurch gekennzeichnet, daß** zwischen den gegenüberliegenden Kontaktflächen (**22**, **24**) elektrisch nicht-leitende Abstandhalterteilchen (**26**) angeordnet werden.

12. Verfahren nach Anspruch 10 oder 11, **dadurch gekennzeichnet, daß** die elektrisch leitenden Partikel (**20**) und die Abstandhalterteilchen (**26**) in dem aufzutragenden Klebstoff (**21**) enthalten sind.

13. Klebstoff zur Flip-Chip-Kontaktierung, der elektrisch leitende Partikel (**20**) zur elektrischen Verbindung gegenüberliegender Kontaktflächen (**22**, **24**) an Substrat (**23**) und Chip (**25**) enthält,
**dadurch gekennzeichnet, daß**
die elektrisch leitenden Partikel (**20**) aus einem unter der Aushärtungstemperatur des Klebstoffs (**21**) schmelzenden Material bestehen und
der Klebstoff (**21**) außerdem elektrisch nicht-leitende Abstandhalterteilchen (**26**) enthält.

14. Verfahren nach Anspruch 11 oder 12 oder Klebstoff nach Anspruch 13, **dadurch gekennzeichnet, daß** die Abstandhalterteilchen (**26**) kleiner sind als die elektrisch leitenden Partikel (**20**).

15. Verfahren nach Anspruch 11 oder 12 oder Klebstoff nach Anspruch 13 oder 14, **dadurch gekennzeichnet, daß** die Abstandhalterteilchen (**26**) aus kompressiblem Material bestehen.

16. Verfahren nach einem der Ansprüche 10 bis 12 oder Klebstoff nach einem der Ansprüche 13 bis 15, **dadurch gekennzeichnet, daß** die elektrisch leitenden Partikel (**20**) aus einem Lot bestehen.

17. Verfahren oder Klebstoff nach Anspruch 16, **dadurch gekennzeichnet, daß** der Klebstoff (**21**) Fluxmitteleigenschaften aufweist.
